# EUROPÄISCHE PATENTSCHRIFT

(11) **EP 0 970 494 B1**
(45) Veröffentlichungstag und Bekanntmachung des Hinweises auf die Patenterteilung: **27.07.2005**
(21) Anmeldenummer: 98920475.5
(22) Anmeldetag: 05.03.1998
(51) Int. Cl.: H01F 38/30, H02M 7/00

(54) **BAUGRUPPE ZUM SCHALTEN ELEKTRISCHER LEISTUNGEN**
SUBASSEMBLY FOR SWITCHING ELECTRIC ENERGY
ENSEMBLE POUR LA COMMUTATION D'INSTALLATIONS D'ENERGIE

(30) Priorität: 04.04.1997 DE 19713984
(43) Veröffentlichungstag der Anmeldung: 12.01.2000
(73) Patentinhaber: Continental ISAD Electronic Systems GmbH & Co. oHG, 86899 Landsberg/Lech (DE)
(72) Erfinder: GRÜNDL, Andreas, D-81377 München (DE); HOFFMANN, Bernhard, D-82319 Starnberg (DE)
(74) Vertreter: Schmidt, Steffen J., Dipl.-Ing.
(86) Internationale Anmeldenummer: PCT/EP1998/001261
(87) Internationale Veröffentlichungsnummer: WO 1998/045861

(56) Entgegenhaltungen:
- EP-A- 0 586 793
- WO-A-94/27157
- US-A- 5 004 974

## Beschreibung

Die vorliegende Erfindung betrifft eine Baugruppe zum Schalten elektrischer Leistungen, bei der wenigstens ein Halbleiterschalter in einer Leistungselektronikbaugruppe angeordnet ist.

Derartige Leistungselektronikbaugruppen sind z.B. in Form von Halbbrückenanordnungen zur Bildung von Wechselrichtern für die unterschiedlichsten Anwendungsbereiche, z.B. zur Speisung von Drehfeldmaschinen, Permanentmagnetmotoren und dergl. im Einsatz (siehe z.B. DE-A-40 27 969).

Allerdings besteht hier das Problem, daß die Leistungsdichte, d.h. die abgegebene Leistung bezogen auf das Volumen der Anordnung bei den herkömmlichen Anordnungen relativ gering ist. Außerdem ist das Gewicht der herkömmlichen Anordnungen relativ hoch.

Aus der US-PS 5,132,896 ist eine Wechselrichteranordnung bekannt, die zur Verringerung der Wirkung verteilter Induktivitäten der Leiter, die zum Verbinden der Kondensatoren und der Halbleiterschalter verwendet werden, plattenförmige Zuleitungen mit großer Fläche aufweist. Dadurch werden große Dämpfungskondensatoren zur Kompensation der Leitungsinduktivitäten vermieden. Außerdem kann durch die großflächige Gestaltung der plattenförmigen Zuleitungen die Wärmeabstrahlung verbessert werden. Des weiteren sind die plattenförmigen Zuleitungen so gestaltet, daß die Größe und die Richtung des Stromflusses durch die plattenförmigen Zuleitungen die Wirkung der verteilten Induktivitäten minimieren.

Allerdings dienen bei dieser Wechselrichteranordnung die größflächigen Zuleitungen lediglich der Minderung von Störinduktivitäten und sind als Zuleitungen zu großen Elektrolytkondensatoren eingesetzt.

Aus der EP 586 793 B1 ist eine Halbbrückenanordnung bekannt, die demgegenüber eine erheblich verbesserte Leistungsdichte hat. Dabei ist der eingangs beschriebene Halbleiterschalter in einer Halbbrückenanordnung angeordnet, die dahingehend weitergebildet ist, daß die Kondensatoranordnung durch wenigstens einen Flächenkondensator an einer mehrere derartiger Halbleiterschalter tragenden Platine und/oder durch wenigstens einen als Hohlwickel geformten Wickelkondensator gebildet ist, wobei die Halbleiterschalter in dem als Hohlwickel gebildeten Wickelkondensator angeordnet sind und eine Fluidkühlung in dem Hohlwickel vorgesehen ist. Auf den Inhalt dieser Druckschrift wird hiermit ausdrücklich Bezug genommen. Die EP-A-586 793 offenbart eine Baugruppe nach dem ersten Teil des Anspruchs 1.

Ausgehend hiervon betrifft die Erfindung Weiterentwicklungen dieser bekannten Anordnung, die dazu dienen die Leistungsdichte weiter zu steigern, die Anwendungsbereiche dieser Anordnung zu vergrößern und die Herstellung und den Betrieb dieser Anordnung kostengünstiger, einfach und sicherer zu machen.

Gemäß einem Aspekt der Erfindung wie beansprucht ist bei der Baugruppe ein Halbleiterschalter in einem Behälter angeordnet, der teilweise mit einer Inertflüssigkeit gefüllt ist, um im Betrieb eine Fluidkühlung des Halbleiterschalters zu bewirken; ist an einer Platine eine magnetfeldempfindliche Sonde angeordnet; ist an einem weiteren Bauteil eine stromführende Leitung angeordnet, die durch ein Bauteil zur Magnetfeldkopplung geführt ist; wobei die Platine mit der Sonde und dem weiteren Bauteil durch die Montage so zueinander ausgerichtet sind, daß die Sonde in das Bauteil zur Magnetfeldkopplung eintaucht, und wobei das magnetfeldhoppelnde Bauteil eine Schwächungsstelle aufweist wie in Anspruch 1 angegeben.

Diese Anordnung stellt eine sehr einfache und fehlerunanfällige Anordnung zur Strommessung in der Halbbrückenanordnung bereit, die kostengünstig ist, keinerlei Stecker erfordert, da die Sonde und die Leitung durch das magnetfeldkoppelndes Bauteil verbunden werden, ohne daß eine elektrische Verbindung notwendig ist.

Vorzugsweise ist die Sonde auf einer Platine angeordnet, die eine Steuerschaltung (CPU) trägt oder mit einer Steuerschaltung verbunden ist, wobei die Steuerschaltung dazu eingerichtet ist, ein von der Sonde erzeugtes Signal zur Bestimmung eines durch die stromführende Leitung fließenden Stromes auszuwerten.

In einer bevorzugten Ausführungsform der Erfindung ist die Sonde eine Hallsonde. Es sind jedoch auch andere Sensortypen einsetzbar.

In einer bevorzugten Ausführungsform der Erfindung ist das magnetfeldkoppelnde Bauteil ein Blechpaket, das eine Durchführung für die stromführende Leitung und eine Koppelstelle für die Sonde aufweist.

Vorzugsweise ist das Blechpaket im Querschnitt C-förmig, wobei die beiden freien Schenkel soweit voneinander beabstandet sind, daß zwischen ihnen die Sonde eingreift. Außerdem ist durch den freien Raum in dem im Querschnitt C-förmigen Blechpaket die stromführenden Leitung gelegt.

In einer bevorzugten Ausführungsform der Erfindung ist das Blechpaket an einem Trägerbauteil angebracht, das zu der Platine, die die Sonde trägt, im montierten Zustand in räumlich festgelegter Beziehung steht. Beispielsweise kann dieses Trägerbauteil ein Anschluß-Stecker oder eine Anschluß-Buchse für die Strom einspeisenden oder abführenden Leitungen in den/aus dem Behälter sein.

Erfindungsgemäß wird vor der ersten Inbetriebnahme, aber auch im Falle von Wartungen oder Justagen mit folgendem Verfahren gemäß Anspruch 8 die Strommessung in der vorstehend beschriebenen Anordnung kalibriert :
a) räumliches Zusammenbringen und Fixieren der die Sonde tragenden Platine und des das magnetfeldkoppelnde Bauteil tragenden Trägerbauteils, wobei die Sonde in das magnetfeldkoppelnde Bauteil eintaucht,
b) Beschicken der Leitung mit einem Strom vorbestimmter Form, Amplitude und/oder Frequenz, und
c) gleichzeitiges Erfassen eines Ausgangssignals der Sonde mittels der Steuerschaltung,
d) das erfaßte Ausgangssignal mit der vorbestimmten Amplitude und/oder Frequenz des Stroms in Beziehung setzen und in einem Speicher der Steuerschaltung abspeichern, und
e) Wiederholen der Schritte b), c) und d), wobei der Schritt b) mit einem Strom wechselnder Amplitude und/oder Frequenz ausgeführt wird, bis eine ausreichende Anzahl von Stützstellen ermittelt ist, um eine Kalibrierkurve mit vorbestimmter Genauigkeit zu ermitteln.

Dabei versteht sich, daß der Schritt a) nur dann ausgeführt werden muß, wenn die Platine mit der Sonde und das Trägerbauteil mit dem magnetfeldkoppelnden Bauteil in ihrer räumlichen Beziehung verändert wurden.

Der Schritt b), bei dem die Leitung mit Strom beschickt wird, kann durch unterschiedliche Maßnahmen bewirkt werden.

Eine erste Möglichkeit besteht darin, direkt den Strom der Leitung von außen einzuprägen. Dies erfordert jedoch eine externe Stromquelle.

Als Alternative zu dieser Lösung kann auch die Leistungselektronikbaugruppe so mit Strom bzw. Spannung gespeist werden, daß in der stromführenden Leistung ein bekannter Strom hervorgerufen wird. Dieser bekannte Strom wird dann mit dem Ausgangssignal der Sonde in Beziehung gesetzt.

Eine weitere Alternative besteht darin, die stromführende Leitung mit einer definierten (induktiven, kapazitiven und/oder ohmschen) Last abzuschließen und durch eine externe Vergleichstrommessung Meßwerte zu erhalten, die mit den Ausgangssignalen der Sonde in Beziehung gesetzt werden.

Die Anordnung ist auf zwei voneinander trennbare bzw. zusammenfügbare Komponenten (Platine einerseits und weiteres Bauteil andererseits) aufgeteilt, die beide in einem gemeinsamen Gehäuse aufgenommen sind. Damit kann die Montage der Anordnung sehr einfach durchgeführt werden, in dem diese beiden Komponenten nacheinander oder gemeinsam in das Gehäuse eingebracht werden, ohne daß es auf die genaue mechanische Fixierung und Orientierung der Komponenten ankäme. Vielmehr kann durch die einfache Kalibrierung der Anordnung die tatsächliche Position der beiden Komponenten zueinander angeglichen werden. Entscheidend ist lediglich, daß die Lage der beiden Komponenten zueinander sich nicht ändert, nachdem die Kalibrierung ausgeführt ist. Ansonsten muß die Kalibrierung wiederholt werden.

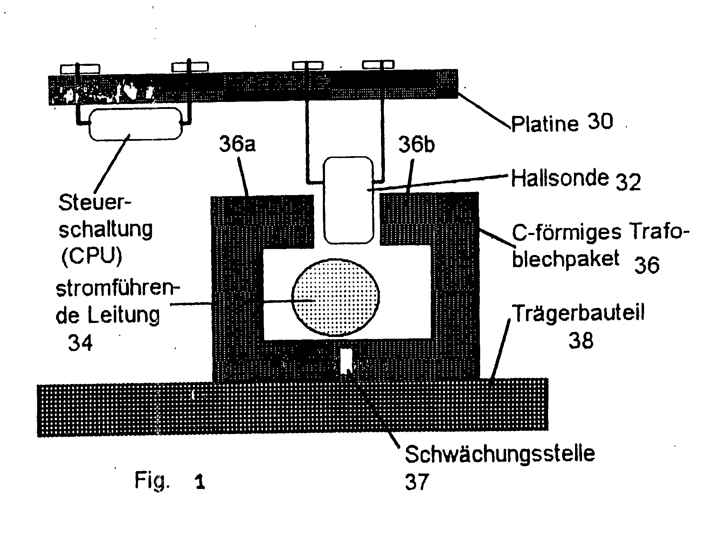

Weitere Eigenschaften, Merkmale und alternative Ausgestaltungen der Erfindung werden nachstehend unter Bezugnahme auf die Zeichnung erläutert, in der die derzeit bevorzugte Ausführungsform des Erfindungsgegenstandes veranschaulicht ist.

Die erfindungswesentlichen Aspekte sind beispielhaft in einer Halbbrückenanordnung verwirklicht, wobei als ein mögliches Anwendungsbeispiel für eine solche Halbbrückenanordnung ein einphasiger Wechselrichter dienen kann, der mit zwei identischen Halbbrückenanordnungen aufgebaut ist. Lediglich zur Erläuterung wird daher nachstehend der prinzipielle Aufbau einer solchen Anordnung erläutert.

Die Halbbrückenanordnung weist parallel geschaltete Paare MOSFETs auf, die als Halbleiterschalter wirken. Jeweils zwei der MOSFETs sind in Serie geschaltet, so daß jeweils der erste MOSFET jedes Paares mit seinem Source-Anschluß auf einem hohen Spannungspotential V_{SS} liegt, und jeder zweite MOSFET jedes Paares mit seinem Drain-Anschluß auf einem niedrigen Spannungspotential V_{DD} liegt. Dabei ist zur Bildung eines Ausgangsanschlusses der Drain-Anschluß jedes der ersten MOSFETs mit dem Source-Anschluß jedes der zweiten MOSFETs verbunden. Jeweils eine Ansteuereinrichtung für die Gruppe der ersten MOSFETs bzw. der Gruppe der zweiten MOSFETs ist mit den parallel geschalteten Steuereingängen jeder Gruppe der ersten und zweiten N-Kanal MOSFETs verbunden.

Zwischen dem hohen und dem niedrigen Spannungspotential V_{SS} und V_{DD} ist ein Kondensator angeordnet, der als Stützkondensator wirkt. Die Kondensatoranordnung ist zum einen durch einen Flächenkondensator an einer die MOSFETs tragenden Platine gebildet. Zum anderen ist die Kondensatoranordnung durch einen als Hohlwickel geformten Wickelkondensator gebildet. Der Hohlwickel ist im wesentlichen zylinderförmig gestaltet und besteht aus mehreren Lagen von Kupferschichten und jeweils einer Isolierschicht. Im Innern des als Hohlwickel ausgebildeten Wickelkondensators sind mehrere Platinen mit einzelnen Halbleiteranordnungen übereinandergeschichtet. Der Hohlwickel ist an einem Ende fluiddicht mit einer konvexen Abdeckkappe verschlossen, während er sich am anderen Ende flaschenförmig verjüngt, um in einem Ansatzstutzen auszulaufen, an dem die Anschlüsse für die Versorgungsspannungen, die Ausgangsleitungen, und die Steuerleitungen nach außen treten.

Der Hohlwickel bildet einen Behälter, der bis etwa 15 bar druckfest ausgebildet ist. Das Innere des Hohlwickels ist mit einem flüssigen Fluorkohlenwasserstoff gefüllt, wobei die Flüssigkeit die Halbleiterschalter bedeckt. Dabei ist ein freier Raum zwischen dem Flüssigkeitsspiegel und der Innenwand des Behälters, so daß eine gasförmige Phase des Fluorkohlenwasserstoffs aus der flüssigen Phase austreten kann. Der Gasdruck in dem Hohlwickel ist entsprechend der Gasdruckkurve des Fluorkohlenwasserstoffs zwischen 50 mbar und 3 bar so eingestellt, daß bereits bei geringfügiger Erwärmung der MOSFETs im Betrieb die flüssige Phase der Fluorkohlenwasserstoffs zu sieden beginnt. So ist erreichbar, daß die Temperaturdifferenz zwischen den Halbleiterschaltern und der den Hohlwickel umgebenden Atmosphäre lediglich etwa 10°C beträgt.

Die Gasphase der Inertflüssigkeit wird von außen durch eine an den Behälter angeschlossene Konvektionskühlung oder durch Gebläsekühlung gekühlt. Dabei kondensiert die Gasphase des Fluorkohlenwasserstoffs an der von außen gekühlten Innenwand der Kühlleitungen und wird in flüssiger Form über eine Flüssigkeitsleitung wieder dem flüssigen Fluorkohlenwasserstoff im Innern des Behälters zugeführt, der die MOSFETs umgibt.

In der Figur ist die Erfindung im Detail veranschaulicht, wobei auf einer Platine 30 eine magnetfeld-empfindliche Sonde 32 angeordnet ist. Von der Sonde 32 räumlich getrennt ist eine stromführende Leitung 34 geführt. Dabei ist die Sonde 32 mit der Leitung 34 durch ein magnetfeldkoppelndes Bauteil 36 verbunden.

Die Sonde 32 ist auf einer Platine angeordnet, die eine Steuerschaltung (CPU) trägt, wobei die Steuerschaltung (CPU) dazu eingerichtet ist, ein von der Sonde 32 erzeugtes Signal zur Bestimmung eines durch die stromführende Leitung 34 fließenden Stromes auszuwerten.

Die Sonde 32 ist eine Hallsonde. Das magnetfeldkoppelnde Bauteil 36 ist ein Blechpaket, ein Ferritkern oder ein Eisenpulverteil, das eine Durchführung für die stromführende Leitung 34 und eine Koppelstelle für die Sonde 32 aufweist. Ein Eisenpulverteil erlaubt die Verteilung des Luftspaltes im gesamten Teil 36, so daß die Sonde 32 praktisch formschlüssig in eine Öffnung in dem Teil 36 hineinragen kann. Das Koppelteil 36 ist im Querschnitt C-förmig, wobei die beiden freien Schenkel 36a, 36b soweit voneinander beabstandet sind, daß zwischen ihnen die Sonde 32 hineinragen kann. Das Koppelteil 36 ist an einem Trägerbauteil 38 angebracht, das zu der Flatine 30, die die Sonde 32 trägt, im montierten Zustand in räumlich festgelegter Beziehung steht.

Die in dem Bauteil 36 symmetrisch zu der Sonde 32 angeordnete Schwächungsstelle 37 bewirkt eine Meßbereichtsspreizung des zu messenden Stromes, da in dem bei der Schwächungsstelle 37 verbleibenden Eisenmaterial die magnetische Sättigung früher eintritt. Damit steigt der durch die Sonde 32 meßbare magnetische Fluß zunächst linear mit dem Strom durch die Leitung 34 an. Sobald die Sättigung im Bereich der Schwächungsstelle 37 eintritt, steigt der magnetische Fluß nicht mehr in gleichem Maß wie der Strom durch die Leitung 34. Damit kann eine höhere Empfindlichkeit der Sonde 32 für niedrige Ströme und eine verringerte Empfindlichkeit der Sonde für höhere Strome realisiert werden.

Die vorstehend beschriebene Anordnung wird für eine Strommessung im Betrieb der Anordnung erfindungsgemäß mit folgendem Verfahren kalibriert:
a) räumliches Zusammenbringen und Fixieren der die Sonde tragenden Platine und des das magnetfeldkoppelnde Bauteil tragenden Trägerbauteils, wobei die Sonde in das magnetfeldkoppelnde Bauteil eintaucht,
b) Beschicken der Leitung mit einem Strom vorbestimmter Form, Amplitude und/oder Frequenz, und
c) gleichzeitiges Erfassen eines Ausgangssignals der Sonde mittels der Steuerschaltung,
d) das erfaßte Ausgangssignal mit der vorbestimmten Amplitude und/oder Frequenz des Stroms in Beziehung setzen und in einem Speicher der Steuerschaltung abspeichern, und
e) Wiederholen der Schritte b), c) und d), wobei der Schritt b) mit einem Strom wechselnder Amplitude und/oder Frequenz ausgeführt wird, bis eine ausreichende Anzahl von Stützstellen ermittelt ist, um eine Kalibrierkurve mit vorbestimmter Genauigkeit zu ermitteln.

## Patentansprüche

1. Baugruppe zum Schalten elektrischer Leistungen, mit
- einem Halbleiterschalter, der in einem Behälter angeordnet ist, der teilweise mit einer Inertflüssigkeit gefüllt ist, um im Betrieb eine Fluidkühlung des Halbleiterschalters zu bewirken,
- einem magnetfeldkoppelnden Bauteil (36), durch das eine stromführende Leitung (34) des Halbleiterschalters geführt ist, und
- einer Platine (30), an der eine magnetempfindliche Sonde (32) angeordnet ist, wobei
- die Platine (30) mit der Sonde (32) und das magnetfeldkoppelnde Bauteil (36) so zueinander ausgerichtet sind, daß die Sonde 32 in das magnetfeldkoppelnde Bauteil (36) eintaucht,
**dadurch gekennzeichnet, daß**
- das magnetfeldkoppelnde Bauteil (36) eine Schwächungsstelle (37) aufweist zur Reduzierung des Wertes der magnetischen Sättigung des magnetfeldhoppelnden Bauteils.

2. Baugruppe nach Anspruch 1, bei der
- die Schwächungsstelle (37) in dem magnetfeldkoppelnden Bauteil (36) symmetrisch zu der Sonde (32) angeordnet ist.

3. Baugruppe nach Anspruch 1 oder 2, **dadurch gekennzeichnet, daß**
- die Platine (30) eine Steuerschaltung (CPU) trägt oder mit einer Steuerschaltung verbunden ist, wobei die Steuerschaltung dazu eingerichtet ist, ein von der Sonde (32) erzeugtes Signal zur Bestimmung eines durch die stromführende Leitung (34) fließenden Stromes auszuwerten.

4. Baugruppe nach einem der Ansprüche 1 - 3, **dadurch gekennzeichnet, daß**
- die Sonde (32) ein magnetfeldempfindliches Bauteil, z. B. ein magnetfeldempfindlicher Widerstand, eine Hallsonde oder eine Feldplatte ist.
- die Sonde (32) ein magnetfeldempfindliches Bauteil, z. B. ein magnetfeldempfindlicher Widerstand, eine Hallsonde oder eine Feldplatte ist.

5. Baugruppe nach einem der Ansprüche 1 - 4, **dadurch gekennzeichnet, daß**
- das magnetfeldkoppelnde Bauteil (36) ein Blechpaket ist, ein Ferritkern oder dergl., das eine Durchführung für die stromführende Leitung (34) und eine Koppelstelle für die Sonde (32) aufweist.

6. Baugruppe nach Anspruch 5, **dadurch gekennzeichnet, daß**
- das Blechpaket im Querschnitt C-förmig ist, wobei die beiden freien Schenkel soweit voneinander beabstandet sind, daß zwischen ihnen die Sonde (32) eingreift.

7. Baugruppe nach einem der Ansprüche 1 - 6, **dadurch gekennzeichnet, daß**
- das magnetfeldkoppelnde Bauteil (36) an einem Trägerbauteil (38) angebracht ist, das zu der Platine (30), die die Sonde (38) trägt, im montierten Zustand in räumlich festgelegter Beziehung steht.

8. Verfahren, mit dem eine Strommessung in der Anordnung nach einem der Ansprüche 1 - 7 kalibriert wird, **gekennzeichnet durch** folgende Schritte:
a) räumliches Anordnen der die Sonde (32) tragenden Platine (30) und des magnetfeldkoppelnden Bauteils (36), so daß die Sonde (32) in das magnetfeldkoppelnde Bauteil (36) eintaucht,
b) Beschicken der Leitung (34) mit einem Strom vorbestimmter Form, Amplitude und/oder Frequenz, und
c) gleichzeitiges Erfassen eines Ausgangssignals der Sonde (32) mittels einer Steuerschaltung,
d) das erfaßte Ausgangssignal mit der vorbestimmten Form, Amplitude und/oder Frequenz des Stroms in Beziehung setzen und in einem Speicher der Steuerschaltung abspeichern, und
e) Wiederholen der Schritte b), c) und d), wobei der Schritt b) mit einem Strom wechselnder Amplitude und/oder Frequenz ausgeführt wird, bis eine ausreichende Anzahl von Stützstellen ermittelt ist, um eine Kalibrierkurve mit vorbestimmter Genauigkeit zu ermitteln.

## Claims

1. An assembly for switching electrical power, comprising
- a semiconductor switch which is arranged in a vessel that is partially filled with an inert liquid in order to effect a fluid cooling of the semiconductor switch during operation;
- a magnetic field coupling component (36) through which a current carrying line (34) of the semiconductor switch is routed, and
- a printed circuit board (30) at which a magnetic sensitive probe (32) is arranged, wherein
- the printed circuit board (30) with the probe (32) and the magnetic field coupling component (36) are aligned relative to each other in such a manner that the probe (32) plunges into the magnetic field coupling component (36),
**characterized in that**
- the magnetic field coupling component (34) comprises a weakening site (37) for reducing the value of the magnetic saturation of the magnetic field coupling component.

2. The assembly according to claim 1, wherein
- the weakening site (37) in the magnetic field coupling component (36) is arranged symmetrically to the probe (32).

3. The assembly according to claim 1 or 2, **characterized in that**
- the printed circuit board (30) carries a control circuit (CPU) or is connected with a control circuit, the control circuit being adapted to evaluate a signal generated by the probe (32) to determine a current flowing through the current carrying line (34).

4. The assembly according to one of claims 1 to 3, **characterized in that**
- the probe (32) is a magnetic field sensitive component, e.g. a magnetic field sensitive resistor, a Hall probe or a field plate.

5. The assembly according to one of claims 1 to 4, **characterized in that**
- the magnetic field coupling component (36) is a laminated core, a ferrite core or the like, which comprises a bushing for the current carrying line (34) and a coupling point for the probe (32).

6. The assembly according to claim 5, **characterized in that**
- the laminated core has a C-shaped cross section, the two free legs being spaced from each other by such a distance that the probe (32) engages in between.

7. The assembly according to one of claims 1 to 6, **characterized in that**
- the magnetic field coupling component (36) is mounted to a carrier component (38) which, in the assembled condition, has a spatially fixed relation with the printed circuit board (30) carrying the probe (32).

8. A method with which a current measurement in the arrangement according to one of claims 1 to 7 is calibrated, **characterized by** the following steps:
a) spatially arranging and securing the printed circuit board (30) carrying the probe (32) and the magnetic field coupling component (36) so that the probe (32) plunges into the magnetic field coupling component (36);
b) supplying the line (34) with a current of predetermined shape, amplitude and/or frequency and
c) simultaneous scanning of an output signal of the probe (32) by means of a control circuit;
d) relating the scanned output signal to the predetermined shape, amplitude and/or frequency of the current and storing it in a memory of the control circuit and
e) repeating steps b), c) and d), with step b) being carried out with a current of alternating amplitude and/or frequency until a sufficient number of supporting points is located in order to determine a calibration curve with predetermined accuracy.

## Revendications

1. Ensemble pour la commutation d'installations d'énergie, comprenant
- un commutateur statique disposé dans un récipient rempli partiellement d'un liquide inerte pour obtenir en cours de fonctionnement un refroidissement par fluide du commutateur statique,
- un élément (36) de couplage par champ magnétique, au travers duquel passe un fil conducteur (34) du commutateur statique, et
- une platine (30) sur laquelle est disposée une sonde (32) magnéto-sensible,
- la platine (30) avec la sonde (32) et l'élément (36) de couplage par champ magnétique étant disposés l'un par rapport à l'autre de sorte que la sonde (32) fait immersion dans l'élément (36) de couplage par champ magnétique,
**caractérisé en ce que**
- l'élément (36) de couplage par champ magnétique présente un point d'atténuation (37) pour la réduction de la valeur de la saturation magnétique du composant de couplage par champ magnétique.

2. Ensemble selon la revendication 1, dans le cadre duquel
- le point d'atténuation (37) est disposé symétriquement par rapport à la sonde (32) dans l'élément (36) de couplage par champ magnétique.

3. Ensemble selon la revendication 1 ou 2, **caractérisé en ce que**
- la platine (30) supporte un circuit de commande (CPU) ou est reliée à un circuit de commande, le circuit de commande étant conçu pour évaluer un signal engendré par la sonde (32) afin de déterminer un courant traversant le fil conducteur (34).

4. Ensemble selon l'une des revendications 1 à 3, **caractérisé en ce que**
- la sonde (32) est un élément magnéto-sensible, p.ex. une résistance magnéto-sensible, une sonde de Hall ou une magnétorésistance.

5. Ensemble selon l'une des revendications 1 à 4, **caractérisé en ce que**
- l'élément (36) de couplage par champ magnétique est un noyau constitué de tôles, un noyau de ferrite ou similaire, lequel présente un passage pour le fil conducteur (34) et un point de couplage pour la sonde (32).

6. Ensemble selon la revendication 5, **caractérisé en ce que**
- le noyau constitué de tôles affiche une section en forme de C, les deux bras libres étant si espacés l'un de l'autre que la sonde (32) est engagée entre eux.

7. Ensemble selon l'une des revendications 1 à 6, **caractérisé en ce que**
- l'élément (36) de couplage par champ magnétique est monté sur une pièce support (38) laquelle, à l'état monté, se trouve en relation déterminée dans l'espace par rapport à la platine qui supporte la sonde (32).

8. Procédé servant au calibrage de la mesure du courant dans l'agencement selon l'une des revendications 1 à 7,
**caractérisé par** les étapes suivantes :
a) positionner dans l'espace la platine (30) supportant la sonde (32) et l'élément (36) de couplage par champ magnétique de sorte que la sonde (32) fait immersion dans l'élément (36) de couplage par champ magnétique
b) alimenter un fil conducteur (34) avec un courant de forme, d'amplitude et/ou de fréquence prédéterminée, et
c) saisir simultanément un signal de sortie de la sonde (32) à l'aide d'un circuit de commande,
d) mettre le signal de sortie saisi en rapport avec la forme, l'amplitude et/ou la fréquence prédéterminée du courant et enregistrer celui-ci dans une mémoire du circuit de commande, et
e) répéter les étapes b), c) et d), l'étape b) étant réalisée avec un courant d'amplitude et/ou de fréquence changeante, jusqu'à ce qu'un nombre suffisant de points de repère soit déterminé pour définir une courbe de calibrage avec une précision prédéterminée.
